Europäisches Patentamt

European Patent Office

Office européen des brevets

(11) Publication number: **0 318 068**

**A1**

## EUROPEAN PATENT APPLICATION

(21) Application number: 88202102.5

(22) Date of filing: 15.05.86

(51) Int. Cl.4: **H05K 13/00** , **H05K 13/02** , **H05K 13/04**

(30) Priority: 16.05.85 US 734964

(43) Date of publication of application:
**31.05.89 Bulletin 89/22**

(60) Publication number of the earlier application in accordance with Art.76 EPC: **0 204 451**

(84) Designated Contracting States:
**BE CH DE FR GB IT LI NL SE**

(71) Applicant: **Holcomb, Gregory W.**
**12 Viento**
**Irvine California 92714(US)**

(72) Inventor: **Holcomb, Gregory W.**
**12 Viento**
**Irvine California 92714(US)**

(74) Representative: **Pears, David Ashley et al**
**REDDIE & GROSE 16 Theobalds Road**
**London WC1X 8PL(GB)**

(54) A component lead straightening apparatus.

(57) A first robot (900) picks up components from various component feeders (907-913) and inserts the leads into a pattern of holes in a plate (778). The head (905) of the robot (900) then moves the component body through a predetermined series of oscillatory movements so as to repetitively exercise the component leads restrained in the openings in the plate (778). Sufficient oscillations are employed to straighten the leads. The robot (900) then releases the component and a second robot (920) picks up the component from the plate (778) and inserts it into a printed circuit board at an insertion station (772).

FIG. 1

EP 0 318 068 A1

## A COMPONENT LEAD STRAIGHTENING APPARATUS

The present invention relates to component lead straightening apparatus of the kind set forth in the introductory part of claim 1, in particular for straightening the leads of multi-lead components to be inserted in a printed circuit board.

Apparatus of the kind referred to above is known from US-A-4 500 032 in which the leads are straightened by pushing them into holes having flared or funnel shaped mouths to guide the leads into the holes. Such apparatus does not take account of natural resilience of the leads and the object of the present invention is to provide apparatus which makes possible a more accurate straightening operation.

The apparatus according to the invention is defined in claim 1.

The invention will be described in more detail, by way of example, with reference to the accompanying drawings, in which:

Figure 1 is a perspective view of a component insertion system including apparatus for component lead straightening, component insertion, and lead clinching;

Figure 2 is a cross-sectional view, taken along line 2-2 of Figure 1, illustrating the lead straightener and cutting apparatus;

Figure 3 is a partial cross-sectional view, taken along lines 3-3 of Figure 2, showing the upper and lower lead straightening and cutting plates;

Figure 4 is a top partial broken-away view of the lead straightening and cutting plates;

Figure 5 is a cross-sectional view illustrating a pair of lead funnels defined in the lead straightening and cutting plates;

Figure 6 is a perspective view of the robot arm end effector employed to pick up an electrical component and insert the component leads into the funnels formed in the lead straightening and cutting plates; and

Figures 7(a)-(c) depict a tube feeder and the grasping of components from the tube feeder by the presentation robot.

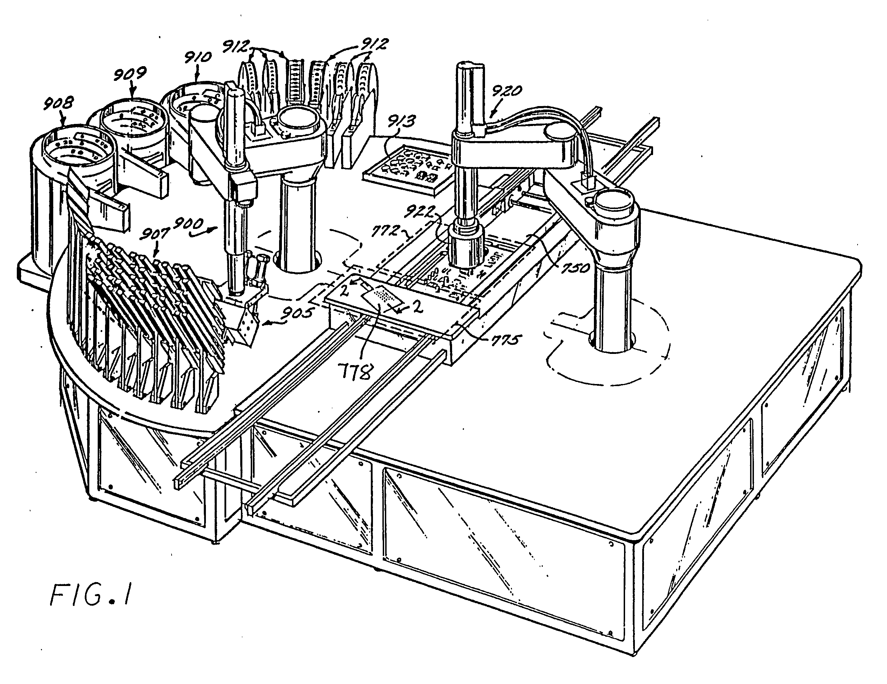

Referring now to Figure 1, a perspective view is shown of a component insertion system embodying the invention. A presentation robot 900 selects a component from one of a plurality of component feeder devices and provides the selected component to a presentation station 775 for lead straightening and cutting An insertion robot 920 retrieves the component at the presentation station and inserts it into the printed circuit board at an insertion station 772, where clinching apparatus clinches the leads of the inserted component. The feeder devices may include tube or stick feeders 907, vibratory bowl feeders 908-910, tape feeders 912, and tray feeders 913, well known per se.

The presentation robot 900 comprises a 4-axis servo robot, marketed by Adept Technology, Inc.. Sunnyvale, California, as in the "Adept One" robot.

The system further comprises a printed circuit board locating and transfer system 750 which automatically transfer the board into and out of the system work cell. The printed circuit board is precisely located at the insertion station 772 by this system during the assembly cycle so that the board position is precisely registered with respect to the component insertion and clinching operations.

The presentation station 775 includes means for straightening the component leads and cutting them to a predetermined length. The lead straightening and cutting means comprises a pair of plates disposed at the presentation station, in combination with the presentation robot 900. In accordance with the invention the presentation robot 900 inserts the component leads into oversized lead openings formed in the straightener/cutter plates, and then oscillates the component body through a predetermined series of movements, bending the leads back and forth in a repetitive exercising motion so as to straighten the leads.

The presentation robot 900 then releases the component body, with its leads clamped in the lead straightening and cutting plates. At this point the component insertion robot 920 moves to the presentation station 775 and its end effector 922 grips the body of the component. If the leads are not to be cut, the lead clamp is released and the part is inserted. However, if the leads are to be cut, the lower plate is moved by a powerful shear cylinder to shear the leads.

The component is then inserted by the insertion robot system 920. In this embodiment, robot 920 comprises a model RT-3000 robot marketed by Seiko Instruments USA Inc.

The apparatus shown in Figure 1 is a general purpose and flexible system adapted to efficiently select a part to be inserted, straighten and cut the leads. and then insert and subsequently clinch the leads to the printed circuit board. The system is highly flexible in that it is not limited to a single board application, but rather is programmable to accommodate a wide variety of printed circuit boards. components. and assembly operations Moreover, no mechanical changes are required to shift from one type of board to another. So long as the required components are made available at the feeder devices, the system can accommodate different board products simply by modifying the system software. This is a substantial advantage over systems which require mechanical retooling to change over from one product to another.

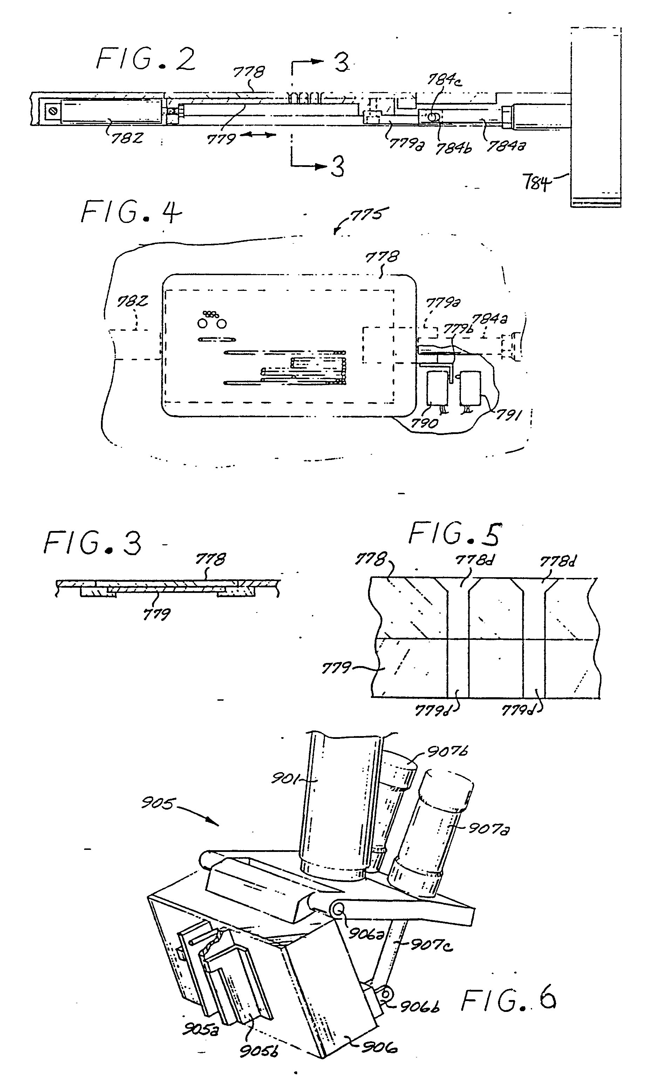

The component presentation station 775 receives the selected component from the presentation robot 900. At this station, the component leads are straightened and cut to a predetermined length. Referring now to Figs. 2-5, the elements at station 775 comprising the component lead straightener and cutting apparatus are disclosed in simplified form.

The lead straightening and cutting apparatus comprises a pair of plates operated in combination with the component presentation robot 900. Straightener plate 778 and shear plate 779 are arranged in a parallel, contiguous relationship. The lateral position of upper plate 778 is fixed. The thickness of straightener plate 778 determines the length of the component leads after the shearing operation. This thickness will depend on the particular application; in the disclosed embodiment, plate 778 has a thickness of 8mm.

A plurality of funnel-shaped openings are formed in the plates 778, 779, defining one or more opening patterns respectively corresponding to the component lead pattern of one or more components. The hole patterns employed in the preferred embodiment extend over a 50 mm by 100 mm rectangular area, to accommodate components as large as 50 mm by 100 mm. There is formed in the plates 778, 779 a plurality of opening patterns which will collectively accommodate the various types of components to be inserted into the particular board, or into a plurality of board types. The system is programmed with information defining the respective position of each opening pattern, and the robot 900 is adapted to insert the respective component into the corresponding opening pattern.

The openings formed in straightening plate 778 are funnel-shaped, as illustrated in the cross-sectional view of Figure 5. The size of the openings will depend on the diameters of the component leads to be inserted, and the component lead spacing. For components having in-line leads, the respective funnel openings may be arranged as series of tangential openings to maximise the ability to insert bent leads into the openings in the straightening plate. A typical opening size is 3 mm at the top of the funnel opening in plate 778, and 1.7 mm at the bottom of the funnel.

Shear plate 779 is mounted in a sliding relationship with respect to straightener plate 778. The position of lower plate 779 in relation to plate 778 is determined by the opposing clamp and shear air cylinders 782 and 784. The air cylinders 782, 784 are secured to opposing ends of lower plate 779 in an axially aligned relationship, as shown in phantom in Fig. 4.

With the plates 778, 779 aligned so that the respective openings in each plate are aligned, the presentation robot is adapted to insert the component leads into the appropriate opening pattern in plates. Air cylinder 782 has a diameter of about 13 mm, to which a supply of pressurised air at 100 psi is selectively coupled through a valve (not shown), to exert a laterally clamping force, typically about 20 pounds on plate 779. The purpose of cylinder 782 is to clamp the leads in position by slightly moving the lower plate in relation to upper plate 778. The clamping force is not sufficient to shear the component leads.

The purpose of shear cylinder 784 is to exert a shearing force on the lower plate 779 so as to forceably move the lower plate 779 in relation to upper plate 778 so as to shear the component leads as they extend below the plate 778. In the disclosed embodiment, the air cylinder 784 has a diameter of 100 mm and a 3.2 mm stroke, and is coupled selectively to a 700 kPa air supply through an air valve (not shown) to exert 5340 N of cutting forces.

Shear cylinder 784 comprises shear arm 784a which is connected to a clevis 779a, secured to the plate 779. The pin 784c extends through slot 784b formed in the arm 784a do secure the clevis 779a to the arm 784a. The slot allows free clamping movement of the lower plate 779 caused by actuation of air cylinder 782, without requiring the clamp cylinder 782 to exert enough force to move the shear cylinder 784.

A pair of microswitch sensors 790, 791 are appropriately arranged to be triggered by arm 779b mounted to the clevis 779a. Sensor 790 indicates that the plates are in the aligned position, and sensor 791 indicates the end-of-travel for the shear motion, providing a positive indication that the shear action has been performed.

The lead straightening and cutting system further comprises the presentation robot 900. The robot 900 employs an end effector 905, shown in Fig. 6, mounted on robot arm 901, to grip the components at the feeder devices. The end effector is adapted for a 45° pitch angle to accommodate gravity feeder tracks, and can be actuated to rotate 45° to squarely present the gripped component to the presentation station 775.

The end effector body member 906 is adapted to rotate about hinge pin 906a in response to the force executed by the air cylinders 907a 906b. The air cylinders comprise arms 907c. 907d. which are secured to corresponding clevis members 906b,c formed on body member 906. The end effector components are cooperatively arranged so that the gripping fingers may be disposed at a 45° angle from the horizontal, or at the horizontal plane.

The end effector 905 comprises two pairs of fingers, an outer pair 905a, 905b, each formed with a respective protruding tang 905c, 905d, and an inner pair 905e, 905f.

The outer fingers 905a, 905b are each mounted for translation in directions normal to the plane of surface 905i, i.e., into and out of the plane defined by surface 905i. Each of fingers 905a, 905b is biased in the extended position illustrated in Fig. 6 by low pressure air cylinders (not shown).

The inner fingers 905e, 905f are arranged for translation toward and away from each other. Their movement is driven by pneumatic air cylinder means (not shown) and is synchronised such that each finger is driven inwardly or outwardly in synchronisation with the other finger. The fingers 905e, 905f are arranged to exert a strong gripping force on the gripped components, greater than 220N, to firmly grip the component for the lead straightening sequence.

The end effector 905 further comprises a hold-down pin 905g which is biased in the extended position shown in Fig. 6 by a spring or air cylinder (not shown), but which may be depressed inwardly. The end effector further comprises a microswitch sensor 905h mounted to indicate when the inner fingers have fully closed. The sensor 905h thus provides a signal that the fingers 905e, 905f have failed to grip a part, since the fingers do not go to the fully closed position when a part has been gripped.

The operation of the end effector is more fully described with reference to Figs. 7(a)-(c). Fig. 7(a) illustrates a partial side view of a tube feeder 925, arranged at a 45° angle from the horizontal. A plurality of components 927 having in-line leads are stored in tube 927. The feeder 925 includes a central rib 925(d). The leads of the components 927 straddle central rib 925(d). The retainer pin 925(c) is passed through the end of rib 925d.

A novel aspect is the L-shaped spring clip 925a secured by fastener 925b to the body of feeder 925. The L-shaped clip 925a further includes a curved tang 925d, and the elongated side 925e forms a 90° angle with retainer portion 925f. While not visible in the side view, retainer portion 925f is about one third the length of side portion 925e.

The purpose of clip 925a is to provide a stop means preventing the leads of components 927 from colliding with pin 925c and thereby bending the leads. With the clip in the position shown in Fig. 7(a) the trailing or back edge of the first component is retained inside the tube, preventing the component from tumbling out of the feeder 925 as the components are loaded.

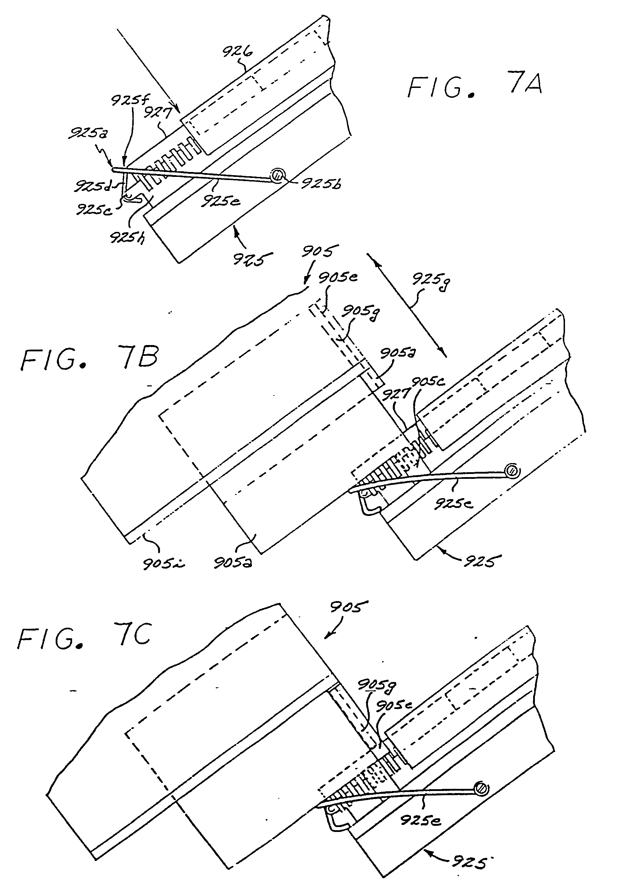

Referring now to Figs. 7(b),(c), side views of the end effector 905 and the feeder 925 are shown, with Fig. 7(b) illustrating an initial contacting position as the end effector initially engages the feeder 925, and Fig. 7(c) illustrating a fully engaged position for extracting the component. The end effector is moved along axis 925g from the position of Fig. 7(b) to that of Fig. 7(c).

The outer finger 905a initially engages the clip 925a, and depresses it out of engagement with the body of component 927. Component 927 then slides down the central rib into engagement with pin 925c. As the effector approaches the feeder 925, the tang 905c engages the body of feeder 925, and as the effector 905 moves to the fully engaged position, the outer finger 905a slides inwardly into surface 905i, against the bias of its corresponding air cylinder.

In the fully engaged position of Fig. 7(c), the inner jaws 905e, 905f are in position to grip the component 972, the hold-down pin 905g having engaged the trailing edge of the component 927 to hold the component down into contact with central rib 925d, allowing the end effector 905 to squarely grip the component 927.

The presentation robot 900 selects one component from the plurality of component feeders. The end effector 905 is adapted to securely grip the body of the selected component for the ensuing lead straightening sequence. In this sequence, the presentation robot moves to the presentation station 775, and inserts the component leads into the corresponding opening pattern in the plates 778, 779, which are in the aligned position. With the leads inserted in the funnel openings and their position substantially constrained, the presentation robot executes a predetermined series of oscillating movements moving the component body with respect to the constrained leads. The particular movements are typically empirically determined for each particular component type. A typical series of movements is to repetitively oscillate the component body in four directions +X, -X, +Y, -Y, 0.8 mm away from the central inserted position.

The oscillatory movements are adapted to flex the leads in one direction (for example, +X) to a minimum yield point, i.e., the deflection at which the lead no longer springs back or returns to its initial position, and then to flex the lead in the opposite direction (-X) from the central position to the opposite yield point. The yield point depends on factors such as the stiffness of the leads and is empirically determined. The leads may then be flexed in the direction (+Y,-Y) normal to the first series of movements. More than one series of movements may be required. Upon completion of the oscillatory movements, the leads will be aligned at averaged positions within a few thousandths of an inch (0.025mm) from the nominal, perfectly aligned condition. It is desirable to minimise the required oscillations, to minimize the risk of breaking the leads.

An aspect of the invention is the flexibility of the system to accommodate virtually any component and straighten its leads sufficiently that the insertion robot can successfully insert the component into the circuit board. Because the funnel openings comprising the opening patterns in the plates 778, 779 are oversized relative to the circuit board opening, the presentation robot is able to insert components into the plates 778, 779 which could not be successfully inserted into the circuit board by the insertion robot because one or more of the component leads are misaligned.

A presentation robot controller includes a peripheral disc drive memory unit, enabling the controller to perform several program functions. The controller controls the movement of the presentation robot arm and end effector, in its part retrieval function. The controller also controls the straightener and cutter operation sequence, and the handshaking performed with the insertion robot to ensure that the operations of the two robots are properly sequenced to avoid collisions.

The above functions are performed by one program for the controller. By another program, the controller communicates with a system controller and controls the operation of the board locating and transfer system. Another program is employed for the manual teaching sequence by which the pick up location and presentation location of each component are loaded into memory. Another program performs safety functions to provide for safe operation following emergency stop of the system, and verification that the position data which has been learned by the controller are regionally correct, i.e., not in conflict with the insertion module.

An insertion robot controller is adapted to carry out a component pick-up and insertion function. The movement of the insertion robot arm and the operation of the end effector are under the control of the controller Other functions performed by this controller include part presence sensing, tactile insertion sensing, handshaking with the clinch system, teaching of the insertion movements and testing.

It is to be understood that the control system is provided with insertion program information for each type of board to be processed. The information defines the sequence by which the various components are to be inserted into the board and their respective board locations. The control system is further provided with information defining the location of each part feeder device and the appropriate component type provided at that feeder device.

The system controller is adapted to coordinate the operation of the above-described components of the component insertion systems. A series of steps occurs in sequence. First, the system 750 (Fig. 1) is operated to convey a circuit board to the insertion station and clamp it in the insertion position. The presentation robot selects the first component from the appropriate feeder device and delivers it to the component presentation station, where the leads are straightened. The presentation robot then releases the component and moves away to select the next component.

The insertion robot then grips the first component at the presentation station and the leads may then be sheared. The insertion robot then inserts the component at its predetermined location on the board. While the insertion robot grips the component in its inserted position, the clinching element clinches predetermined leads of the component. The insertion robot then returns to the presentation station to grip the next component.

These steps are repeated until all the components on the board have been inserted. The system 750 then conveys the finished board away from the insertion station and delivers a new board to the station.

For the sake of clarity, specific details concerning the interfacing of the respective controllers have been omitted. For similar reasons, specific details concerning air valves, motor drivers and peripheral devices for interfacing the system controller with the various elements of the board transfer and locating system 750 and the lead straightening and cutting system 775 are omitted. Such details will be apparent to those skilled in the art from the above description.

An improved component insertion system has been disclosed. The system provides the flexibility of adapting to insertion of different products without mechanical retooling, by changing the controller software. The system enhances the productivity of circuit board assembly lines by substantially reducing the time required to convert the line from assembly of one type of circuit board to another type. Moreover, because retooling is not required, the capital expenditures required to implement an assemble line capable of assembling a plurality of circuit board types may be reduced.

## Claims

1. A component lead straightening apparatus, comprising component feeder means (907-913) for storing a plurality of components; a robot (900) adapted for sequentially picking up components from the component feeder means and delivering the components to a presentation station: a lead straightening plate (778) disposed at the presentation station, the plate having a pattern of openings (778d) in correspondence with the lead pattern of the component; and wherein the robot is adapted to insert the component leads into the openings to straighten the leads, characterised in that the robot (900) is adapted to move the component body through a predetermined series of oscillatory movements so as to repetitively exercise the component leads restrained in the said openings (778d). thereby to substantially straighten the leads.

2. Apparatus according to claim 1, characterised in that the pattern of openings (778d) in the lead straightening plate (778) is adapted to accommodate the respective lead patterns of a plurality of component types.

3. Apparatus according to claim 1 or 2, characterised in that the robot (900) is adapted to select one of a plurality of types of components available at the feeder means (907-913) and in that the series of oscillatory movements is adapted to the selected type of component.

4 Apparatus according to claim 1, 2 or 3, further characterised by cutting means (779) for cutting the leads of the selected component to a predetermined length.

5. Apparatus according to claim 4, characterised in that the cutting means comprises: a shear plate (779) disposed in sliding relation with the straightening plate (778), the shear plate including a pattern of openings (779d) corresponding to the pattern of openings (778d) formed in the straightening plate; means (782,784) for disposing the shear plate in an aligned position relative to the straightening plate so that the corresponding patterns of openings in the plates are aligned, and for subsequently exerting a sliding shear force on the shear plate so as to shear the component leads extending into the openings in the shear plate.

6. Apparatus according to claim 5, characterised in that the means for exerting a sliding shear force on the shear plate comprises a pneumatic cylinder and piston assembly (784).

7. Apparatus according to claim 5, further characterised by a first sensing means (790) for sensing when the shear plate is in said aligned position and providing a first sensor signal indicating said aligned condition, and a second sensing means (791) for sensing the end-of-travel of the shear plate motion and providing a second sensor signal indicating that the shearing action has been performed.

8. Apparatus according to claim 1, 2 or 3, characterised in that the series of oscillatory movements comprises movements of the component body in four directions +x, -x, +y, -y a predetermined distance away from the central inserted position.

9. Apparatus according to claim 1, characterised in that the predetermined distance the component body is moved away from the central inserted position is to minimum yield point at which the component leads no longer spring back or return to the initial position.

10. Apparatus according to claim 1, 2 or 3, further characterised in that the component feeder means comprises one or more tube feeders (925) inclined to the horizontal to provide for gravity feeding of successive components therefrom, and each comprises a retaining means (925a) for retaining the next available component at a pickup location until the feeder device is accessed by the robot.

11. Apparatus according to claim 1, characterised in that the robot (900) comprises an end effector (905) having a pair of gripping jaws (905e, f) and means for controlling the attitude of the jaws relative to the horizontal to a first attitude aligned with said tube feeder (925) for gripping the components at the pickup location and to a second attitude aligned with the horizontal to deliver the components to the presentation station.

12. Apparatus according to claim 10, characterised in that the retaining means further comprises a stop means preventing the leads of components from striking an end stop structure of the feeder and thereby bending the leads.

13. A method for straightening the leads of components in a robotic system including a presentation station, at least one component feeder means for storing a plurality of the components, a robot for sequentially picking up components from said component feeder means and delivering the components to the presentation station, and a lead straightening plate disposed at the presentation station, the plate having a pattern of openings in correspondence with the lead pattern of the component, characterised by the steps of: using the robot to grip a component by its body at the component feeder; and using the robot to insert the leads of the gripped component into the openings pattern of said lead straightening plate and thereafter move the component body through a predetermined series of oscillatory movements so as to repetitively exercise the component leads restrained in the said openings thereby to substantially straighten the leads.

FIG.1

FIG.2

FIG.4

FIG.3

FIG.5

FIG.6

FIG. 7A

FIG. 7B

FIG. 7C

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | US-A-3 779 291 (YEO) <br> * figures 1 - 5; column 1, line 40 - column 7, line 62 * <br> --- | 1-3,8,9 ,13 | H 05 K 13/00 <br> H 05 K 13/02 <br> H 05 K 13/04 |
| A | US-A-3 664 016 (SEVC et al.) <br> * figures 1 - 5; column 2, line 14 - column 5, line 71 * <br> --- | 1-3,8,9 ,13 | |
| A | US-A-4 125 136 (OLCESE et al.) <br> * figures 2, 5 - 9; column 2, line 24 - column 4, line 56 * <br> --- | 1,4-6 | |
| A,D | EP-A-0 120 159 (UNIVERSAL INSTRUMENTS) <br> * figures 1 - 11; claims 1 - 5 * <br> ----- | 1,2,13 | |

TECHNICAL FIELDS SEARCHED (Int. Cl.4)

H 05 K 13/00

The present search report has been drawn up for all claims

| Place of search | Date of completion of the search | Examiner |
|---|---|---|
| BERLIN | 07-02-1989 | HAHN G |

EPO FORM 1503 03.82 (P0401)